# FASCICULE DE BREVET EUROPEEN

(11) **EP 4 129 771 B1**
(45) Date de publication et mention de la délivrance du brevet: **23.07.2025**
(21) Numéro de dépôt: 22188446.3
(22) Date de dépôt: 03.08.2022
(51) Int. Cl.: B60R 13/08, B60R 16/023, B61C 17/00, H05K 5/06, H05K 7/14

(54) **COFFRE, NOTAMMENT POUR UN CONVERTISSEUR ÉLECTRIQUE D'UN VÉHICULE DE TRANSPORT, CONVERTISSEUR ÉLECTRIQUE COMPRENANT UN TEL COFFRE, ET VÉHICULE DE TRANSPORT COMPRENANT UN TEL CONVERTISSEUR**
KASTEN, INSBESONDERE FÜR EINEN ELEKTRISCHEN LEISTUNGSWANDLER EINES TRANSPORTFAHRZEUGS, ELEKTRISCHER LEISTUNGSWANDLER MIT EINEM SOLCHEN KASTEN UND TRANSPORTFAHRZEUG MIT EINEM SOLCHEN LEISTUNGSWANDLER
BOX, IN PARTICULAR FOR AN ELECTRICAL CONVERTER OF A TRANSPORT VEHICLE, ELECTRICAL CONVERTER COMPRISING SUCH A BOX, AND TRANSPORT VEHICLE COMPRISING SUCH A CONVERTER

(30) Priorité: 03.08.2021 FR 2108435
(43) Date de publication de la demande: 08.02.2023
(73) Titulaire: ALSTOM Holdings, 93400 Saint-Ouen-sur-Seine (FR)
(72) Inventeur: DELVAL, Damien, 59600 ASSEVENT (FR); ETCHEVERRY, Bernard, 65000 TARBES (FR); PUEL, Bernard, 65310 LALOUBERE (FR)
(74) Mandataire: Plasseraud IP

(56) Documents cités:
- EP-A1- 1 536 674
- US-A1- 2007 121 288

## Description

La présente invention concerne un coffre ayant en particulier au moins un joint étanche pour empêcher la pénétration de contaminants, notamment d'agents liquides ou de poussière, à l'intérieur du coffre.

Le coffre selon la présente invention est particulièrement adapté pour l'application à un convertisseur électrique, comme par exemple un convertisseur de traction d'un véhicule de transport, et il sera décrit en faisant ici spécifiquement référence à cette application. Toutefois, cette application spécifique ne doit pas être considérée comme limitant la possibilité d'utiliser le coffre selon la présente invention pour toute autre application possible.

Il est bien connu que les coffres sont des structures généralement métalliques comprenant un cadre ou châssis de support et une pluralité de panneaux de revêtement extérieur, qui sont mutuellement assemblés pour délimiter un volume interne destiné à loger des appareils.

Par exemple, dans le cas d'un convertisseur d'alimentation en puissance électrique d'un moteur d'un véhicule de transport, comme un train, le coffre loge au moins une électronique haute-tension et une électronique basse-tension de commande de l'électronique haute-tension à laquelle l'électronique basse-tension est connectée.

En fonction de l'application, chaque coffre doit respecter des standards de protection, indiqués par des degrés ou codes de protection IP (pour « Ingres Protection Code »), qui définissent le niveau de protection atteint contre l'accès d'agents contaminants à l'intérieur du coffre, par exemple contre l'entrée de poussière, de sable et en général de tous petits corps solides, et/ou de liquides.

A cet égard, les connexions entre les panneaux de revêtement sont normalement équipées avec des pièces d'étanchéité, comme par exemple des joints de caoutchouc, ou des cordons de mastic ou tout matériel d'étanchéité équivalent.

Ces solutions permettent la réalisation des joints d'étanchéité mais présentent encore des inconvénients car les pièces d'étanchéité utilisées sont toujours exposées aux agents atmosphériques et peuvent être endommagées. En tout cas, les pièces d'étanchéité utilisées demandent des travaux de maintenance pendant toute la vie effective des coffres, qui peut atteindre quelques dizaines d'années, et ils impliquent un coût non négligeable.

Le document US 2007/121288 A1 divulgue un appareil extérieur comprenant un corps de boîtier principal en forme de boîte qui a une ouverture formée au niveau d'une face avant et qui loge au moins une carte de circuit électronique. Un panneau avant en forme de boîte recouvre l'ouverture avant du corps de boîtier principal. Une plaque supérieure du corps de boîtier principal a une saillie vers le haut et une saillie arrière en forme de plaque qui fait saillie vers l'arrière à partir de la saillie vers le haut. Le panneau avant a une partie qui est courbée perpendiculairement à partir d'une plaque supérieure qui s'oppose à la saillie vers le haut du corps de boîtier principal et entre en contact avec une pointe de la saillie arrière.

Par conséquent, un but principal de la présente invention est de fournir une solution offrant des améliorations par rapport à l'état de l'art connu, et spécialement de réaliser des coffres ayant des joints qui garantissent l'étanchéité, en particulier contre la pénétration de liquides, en permettant en même temps d'éliminer, ou au moins de réduire sensiblement, les travaux de maintenance requis pendant la vie effective d'un coffre.

Ce but est atteint par un coffre, notamment pour un convertisseur électrique d'un véhicule de transport, selon la revendication 1.

Selon des aspects avantageux mais non obligatoires de l'invention, un tel coffre peut incorporer une ou plusieurs des caractéristiques suivantes, prises selon toute combinaison techniquement admissible :
- la portion déformée forme des chicanes ;
- la portion déformée est configurée pour former avec le premier panneau de revêtement au moins une chambre de détente, de préférence au moins trois chambres de détente ;
- la portion déformée est fixée mécaniquement au premier panneau de revêtement au moyen d'un ou plusieurs rivets ;
- la portion déformée a un profil plié en lignes brisées, ou en lignes mixtes brisées-ondulées.

En outre, le but susmentionné de la présente invention est également atteint par un convertisseur électrique, notamment pour un véhicule de transport, caractérisé en ce qu'il comporte au moins un coffre tel que mentionné ci-dessus.

En particulier, ce convertisseur électrique selon l'invention est de préférence un convertisseur de traction ou un convertisseur auxiliaire d'un véhicule ferroviaire.

Enfin, le but susmentionné de la présente invention est également atteint par un véhicule de transport caractérisé en ce qu'il comporte au moins un convertisseur électrique tel que mentionné ci-dessus.

D'autres aspects et avantages de l'invention apparaîtront à la lecture de la description qui suit, donnée uniquement à titre d'exemple et faite en référence aux dessins annexés, parmi lesquels :
[FIG. 1] la Figure 1 est une vue illustrant un exemple possible d'un coffre métallique selon l'invention ;
[FIG. 2] la Figure 2 est une section verticale partielle du coffre de la figure 1, qui illustre schématiquement un exemple de réalisation possible d'un joint étanche utilisable dans un coffre métallique, non conforme aux revendications ;
[FIG. 3] la Figure 3 est une vue partielle de dessus qui illustre schématiquement un autre exemple de réalisation possible d'un joint étanche utilisable dans un coffre métallique selon l'invention.

Il est à noter que dans la description détaillée qui suit, les composants identiques ou similaires, du point de vue structurel et/ou fonctionnel, portent les mêmes références numériques, qu'ils soient représentés ou non dans des modes de réalisation différents de la présente description.

Il convient également de noter que, pour décrire de manière claire et concise la présente invention, les dessins ne sont pas nécessairement à l'échelle et que certaines caractéristiques peuvent être présentées sous une forme schématique.

En outre, lorsque le terme "adapté" ou "agencé" ou "configuré" est utilisé ici en se référant à tout composant dans son ensemble, ou à toute partie d'un composant, ou à une combinaison de composants, il doit être compris que cela signifie et englobe la structure et/ou la configuration et/ou la forme et/ou le positionnement du composant ou de la partie que ce terme désigne.

En outre, lorsque les termes "substantiellement" ou "sensiblement" sont utilisés ici, ils doivent être compris comme englobant une possible variation de plus ou moins 5% par rapport à une valeur ou une position de référence indiquée.

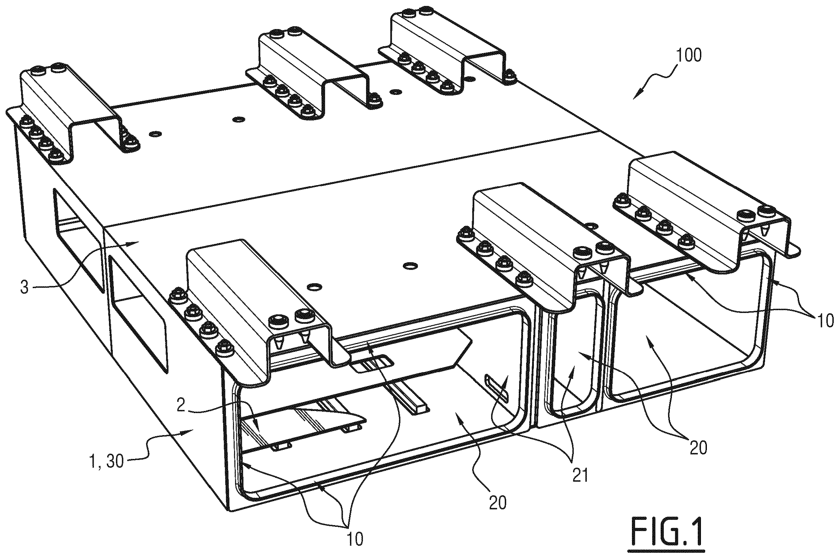

La figure 1 illustre un exemple de réalisation possible d'un coffre selon la présente invention, notamment un coffre métallique, désigné avec le numéro de référence 100 et ayant par exemple une forme globalement parallélépipédique.

Comme ci-dessus mentionné, le coffre métallique 100 selon l'invention est particulièrement adapté pour être utilisé avec un convertisseur électrique d'un véhicule de transport et à cet égard le coffre 100 représenté sur la figure 1 est un coffre métallique pour un convertisseur de traction d'un véhicule ferroviaire, tel qu'un train.

Toutefois, la définition de « véhicule de transport » utilisée ici doit être interprétée dans le sens le plus large possible, c'est-à-dire comme incluant tout type de véhicule de transport possible, comme par exemple les trams, les métropolitains, les bus, et similaires.

En outre, comme l'homme du métier comprendra aisément à la lecture de la description suivante, le coffre 100 selon l'invention peut avoir une forme différente de celle illustrée sur la figure 1 et décrite ci-dessous.

Comme illustré sur la figure 1, le coffre métallique 100 comprend : un cadre ou châssis de support comprenant plusieurs montants métalliques, tous désignés par la même référence 10, qui délimitent par exemple des faces sensiblement rectangulaires ; et une pluralité de panneaux de revêtement 1, 2, 3, qui sont liés l'un à l'autre et/ou aux montants 10.

Les panneaux de revêtement 1, 2, 3 définissent les bords périmétriques du coffre 100, en délimitant un volume interne 20 du coffre 100, propre à loger un ou plusieurs appareil(s), comme par exemple des appareils électriques ou électroniques.

En fonction des applications, le volume interne 20 peut être un seul espace, ou il peut être divisé en deux ou plusieurs espaces par des parois 21 de séparation interne, comme par exemple illustré sur la figure 1.

En outre, au moins un des panneaux de revêtement peut par exemple remplir la fonction de porte d'ouverture/fermeture du coffre 100, et est donc lié au cadre de support 10 de façon mobile.

Chaque panneau de revêtement 1, 2, 3 est par exemple formé par une plaque métallique.

Le coffre métallique 100 selon l'invention comporte au moins un panneau métallique, indiqué sur les figures 1 à 3 par le numéro de référence 30, qui inclut au moins une portion déformée 31 qui est fixée mécaniquement à au moins un premier panneau 1 de revêtement.

En particulier, la portion déformée 31 est configurée pour former, avec le premier panneau de revêtement 1 et sans apport de matériel d'étanchéité, un bord 32 substantiellement étanche à la pénétration d'agents contaminants, notamment de liquides et/ou de la poussière, à l'intérieur du volume interne 20.

Selon un mode de réalisation possible, la portion déformée 31 est configurée pour former des chicanes qui contribuent à rendre le bord 32 substantiellement étanche.

En particulier, selon un mode de réalisation possible, la portion déformée 31 est configurée pour former avec le premier panneau de revêtement 1 au moins une chambre de détente ou décompression 33. La portion déformée 31 forme ainsi les chicanes qui contribuent à rendre le bord 32 substantiellement étanche.

De préférence, la portion déformée 31 est configurée pour former avec le premier panneau de revêtement 1 une pluralité de chambres de détente qui contribuent à former le réseau de chicanes et font partie également de la fonction étanchéité du bord 32.

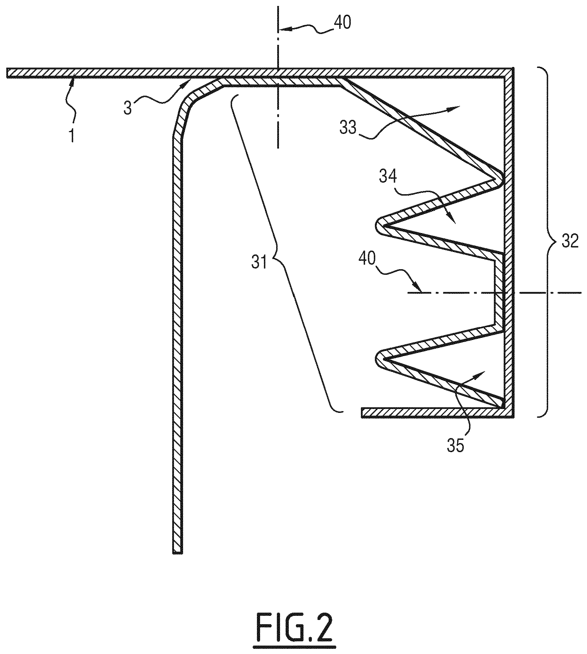

En particulier, la portion déformée 31 est configurée pour former avec le premier panneau 1 de revêtement au moins trois chambres de détente ou décompression 33, 34, 35, comme illustré par exemple sur la figure 2.

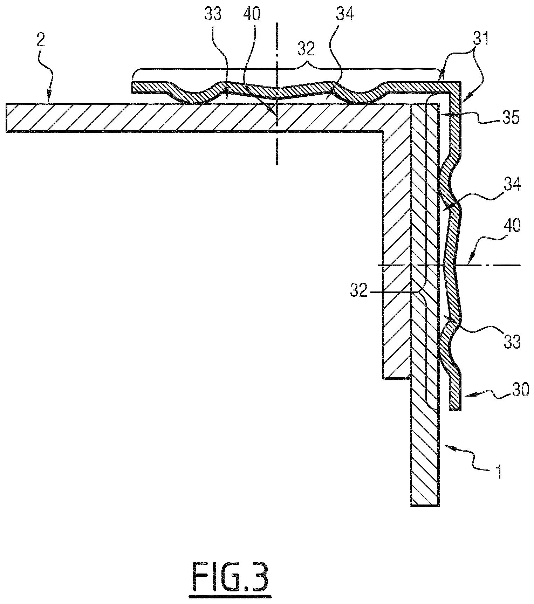

Selon une forme de réalisation possible, la portion déformée 31 est fixée mécaniquement au premier panneau de revêtement 1 avec des moyens de fixation, de préférence au moyen d'un ou plusieurs rivets, qui sont représentés schématiquement sur les figures 2 et 3 avec le numéro de référence 40.

En outre, certaines parties de la portion déformée 31 peuvent être mécaniquement enfoncées contre la surface de fixation du premier panneau 1 pour améliorer la liaison mécanique.

Selon une forme de réalisation possible, la portion déformée 31 a un profil plié en lignes brisées, ou en ligne mixtes brisées-ondulées, par exemple en forme d'accordéon, comme illustré sur les figures 2 et 3. Ces plis forment des chicanes.

Selon une forme de réalisation possible, non conforme aux revendications annexées, le panneau métallique 30 incluant la portion déformée 31 est constitué par un panneau de revêtement sélectionné parmi la pluralité de panneaux de revêtement 1, 2, 3.

Dans ce cas, comme illustré schématiquement sur les figures 1 et 2, le panneau métallique 30 est constitué par exemple par le panneau de revêtement 1, agencé latéralement au coffre 100. En particulier, le panneau de revêtement 1 se développe de façon substantiellement verticale et sa portion déformée 31 est fixée au panneau de revêtement 3 qui est agencé du côté supérieur du coffre 100 et forme le toit ou fait partie de la toiture du coffre 100.

Selon cet exemple de réalisation, le panneau métallique 30 remplit donc en même temps deux fonctions, à savoir une première fonction de fermeture latérale du coffre, et une deuxième fonction d'assurer l'étanchéité de la liaison mécanique avec le toit.

Selon l'invention, le panneau métallique 30 incluant la portion déformée 31 est constitué par un panneau métallique supplémentaire fixé à l'extérieur du premier panneau de revêtement 1.

En particulier, en accord avec cette variante de réalisation et comme illustré par exemple sur la figure 3, la pluralité de panneaux de revêtement comporte un premier panneau de revêtement latéral 1 et un deuxième panneau de revêtement latéral 2 qui sont liés l'un à l'autre en formant un coin, par exemple à angle droit. Le panneau métallique 30 supplémentaire comporte une configuration angulaire et est agencé de manière que sa portion déformée 31 est disposée autour du coin et est fixée aux premier et deuxième panneaux de revêtement latéraux 1, 2.

Dans ce cas, la portion déformée 31 forme par exemple une première chambre de détente ou décompression 33 avec chacun du premier et du deuxième panneaux 1, 2. De préférence, la portion déformée 31 forme une deuxième chambre de détente ou décompression 34 avec le premier panneau 1 et avec le deuxième panneau 2. En outre, selon l'exemple illustré à la figure 3, une seule troisième chambre de détente ou décompression 35 est formée au niveau du coin entre le panneau supplémentaire 30 et les premier et deuxième panneaux latéraux 1 et 2.

Bien entendu, il est possible de réaliser deux troisièmes chambres de détente ou décompression 35 séparées, l'une formée entre le panneau supplémentaire 30 et le premier panneau latéral 1, et l'autre formée entre le panneau supplémentaire 30 et le deuxième panneau latéral 2.

Il ressort clairement de la description qui précède que le coffre métallique 100 permet d'atteindre le but à la base de la présente invention.

En effet, dans le coffre 100 selon l'invention, le bord 32 étanche à la pénétration des agent contaminants, en particulier de liquides, est constitué par l'ensemble de la chambre de détente ou décompression 33 ou de préférence de la pluralité de chambres de détente ou décompression 33, 34 et 35, et des moyens de fixation, notamment les rivets 40. Il est réalisé donc sans apport d'aucun matériel d'étanchéité supplémentaire, du type mastic.

En particulier, la ou les chambre(s) de décompression 33, 34, 35 forment une séquence de salles de chute de pression afin d'obtenir une chute de pression efficace le long d'un chemin potentiel de liquide ou de poussière et éviter ainsi leur pénétration dans le volume interne 20. Par exemple, si un liquide, comme de l'eau, franchit la première chambre, sa pression se réduira chambre après chambre par rapport à la pression extérieure du liquide et à la fin, par exemple dans la troisième chambre 35, l'eau retombera par gravité sans entrer dans le volume 20.

De cette façon, le bord 20 permet de résister à des effets de pressions aux liquides tels que définis par l'indice de protection du type IPX6 selon la norme EN60529 de mai 2014.

Ces résultats sont obtenus avec une solution relativement simple du point de vue constructif et très flexible à appliquer, en permettant d'obtenir une étanchéité horizontale et/ou verticale par rapport à une direction d'un jet de liquide perpendiculaire par exemple au panneau 1, ou 2, ou 3.

En particulier, le coffre 100 selon l'invention est particulièrement adapté pour être appliqué à des convertisseurs électriques, notamment des convertisseurs de traction ou des convertisseur auxiliaires, de véhicules de transport, tels que des trains. En conséquence, la présente invention concerne également un convertisseur électrique, notamment pour un véhicule de transport, qui comporte au moins un coffre métallique comme ci-dessus décrit.

Le convertisseur électrique est par exemple installé à bord d'un véhicule de transport, et en particulier, grâce au degré de protection IPX6 de son coffre 100, peut être utilisé dans conditions de fonctionnement très exigeantes, en étant par exemple installé sous la caisse ou même sur le toit du véhicule de transport.

Le coffre 100 et le convertisseur électrique ainsi conçus sont susceptibles de modifications et de variations.

## Revendications

1. Coffre (100), notamment pour un convertisseur électrique d'un véhicule de transport, comportant un cadre de support (10) et une pluralité de panneaux de revêtement (1, 2, 3) délimitant un volume interne (20) propre à loger un ou plusieurs appareil(s) et comprenant au moins un panneau métallique (30), dans lequel le panneau métallique (30) inclut au moins une portion déformée (31) qui est fixée mécaniquement à au moins un premier panneau de revêtement (1), la portion déformée (31) étant configurée pour former, avec le premier panneau de revêtement et sans apport de matériel d'étanchéité, un bord (32) substantiellement étanche à la pénétration de liquide et/ou de poussière à l'intérieur du volume interne (20), le coffre (100) étant **caractérisé en ce que** le panneau métallique (30) incluant la portion déformée (31) est constitué par un panneau métallique supplémentaire fixé à l'extérieur du premier panneau de revêtement (1), dans lequel la pluralité de panneaux de revêtement (1, 2, 3) comporte un premier panneau de revêtement latéral et un deuxième panneau de revêtement latéral qui sont liés l'un à l'autre en formant un coin et dans lequel le panneau métallique (30) supplémentaire comporte une configuration angulaire et est agencé de manière que sa portion déformée (31) est disposée autour du coin et est fixée aux premier et deuxième panneaux de revêtement latéraux (1, 2).

2. Coffre (100) selon la revendication 1, dans lequel la portion déformée (31) forme des chicanes.

3. Coffre (100) selon la revendication 1 ou 2, dans lequel la portion déformée (31) est configurée pour former avec le premier panneau (1) de revêtement au moins une chambre de détente (33, 34, 35), de préférence au moins trois chambres de détente (33, 34, 35).

4. Coffre (100) selon l'une quelconque des revendications précédentes, dans lequel la portion déformée (31) est fixée mécaniquement au premier panneau (1) de revêtement au moyen d'un ou plusieurs rivets (40).

5. Coffre (100) selon l'une quelconque des revendications précédentes, dans lequel la portion déformée (31) a un profil plié en lignes brisées, ou en lignes mixtes brisées-ondulées.

6. Convertisseur électrique, notamment pour un véhicule de transport, **caractérisé en ce qu'**il comporte au moins un coffre (100) selon l'une quelconque des revendications précédentes.

7. Véhicule de transport **caractérisé en ce qu'**il comporte au moins un convertisseur électrique selon la revendication 6.

## Patentansprüche

1. Kasten (100), insbesondere für einen elektrischen Wandler eines Transportfahrzeugs, mit einem Tragrahmen (10) und einer Mehrzahl von Verkleidungsplatten (1, 2, 3), die einen Innenraum (20) begrenzen, der zur Aufnahme eines oder mehrerer Geräte geeignet ist, und wenigstens eine Metallplatte (30) umfasst, wobei die Metallplatte (30) wenigstens einen verformten Abschnitt (31) aufweist, der mechanisch an wenigstens einer ersten Verkleidungsplatte (1) befestigt ist, wobei der verformte Abschnitt (31) dazu ausgebildet ist, mit der ersten Verkleidungsplatte und ohne Zugabe von Dichtungsmaterial einen Rand (32) zu bilden, der im Wesentlichen dicht gegen das Eindringen von Flüssigkeit und/oder Staub in das Innenvolumen (20) ist, wobei der Kasten (100) **dadurch gekennzeichnet ist, dass** die Metallplatte (30) mit dem verformten Abschnitt (31) aus einer zusätzlichen Metallplatte besteht, die an der Außenseite der ersten Verkleidungsplatte (1) befestigt ist, wobei die Mehrzahl von Verkleidungsplatten (1, 2, 3) eine erste seitliche Verkleidungsplatte und eine zweite seitliche Verkleidungsplatte umfassen, die unter Bildung einer Ecke miteinander verbunden sind, und wobei die zusätzliche Metallplatte (30) eine winklige Konfiguration aufweist und so angeordnet ist, dass ihr verformter Abschnitt (31) um die Ecke herum angeordnet und an der ersten und zweiten seitlichen Verkleidungsplatte (1, 2) befestigt ist.

2. Kasten (100) nach Anspruch 1, wobei der verformte Abschnitt (31) Leitbleche bildet.

3. Kasten (100) nach Anspruch 1 oder 2, wobei der verformte Abschnitt (31) dazu ausgebildet ist, mit der ersten Verkleidungsplatte (1) wenigstens eine Entspannungskammer (33, 34, 35), bevorzugt wenigstens drei Entspannungskammern (33, 34, 35) zu bilden.

4. Kasten (100) nach einem der vorhergehenden Ansprüche, wobei der verformte Abschnitt (31) mittels einer oder mehrerer Nieten (40) mechanisch an der ersten Verkleidungsplatte (1) befestigt ist.

5. Kasten (100) nach einem der vorhergehenden Ansprüche, wobei der verformte Abschnitt (31) ein gebrochenes oder gemischt gebrochenes und gewelltes Profil aufweist.

6. Elektrischer Wandler, insbesondere für ein Transportfahrzeug, **dadurch gekennzeichnet, dass** er wenigstens einen Kasten (100) nach einem der vorhergehenden Ansprüche umfasst.

7. Transportfahrzeug, **dadurch gekennzeichnet, dass** es wenigstens einen elektrischen Wandler nach Anspruch 6 umfasst.

## Claims

1. Box (100), in particular for an electrical converter of a transport vehicle, including a support frame (10) and a plurality of cladding panels (1, 2, 3) delimiting an internal volume (20) suitable for housing one or more pieces of equipment and comprising at least one metal panel (30), wherein the metal panel (30) includes at least one deformed portion (31) that is mechanically attached to at least one first cladding panel (1), the deformed portion (31) being configured to form, with the first cladding panel and without the addition of sealing material, an edge (32) substantially sealed to the penetration of liquid and/or dust inside the internal volume (20), the box (100) being **characterised in that** the metal panel (30) including the deformed portion (31) is constituted of an additional metal panel attached to the exterior of the first cladding panel (1), wherein the plurality of cladding panels (1, 2, 3) comprises a first lateral cladding panel and a second lateral cladding panel that are connected to each other forming a corner, and wherein the additional metal panel (30) comprises an angular configuration and is arranged such that its deformed portion (31) is disposed around the corner and is attached to the first and second lateral cladding panels (1, 2).

2. Box (100) according to claim 1, wherein the deformed portion (31) forms zigzags.

3. Box (100) according to claim 1 or 2, wherein the deformed portion (31) is configured to form with the first cladding panel (1) at least one expansion chamber (33, 34, 35), preferably at least three expansion chambers (33, 34, 35).

4. Box (100) according to any one of the preceding claims, wherein the deformed portion (31) is mechanically attached to the first cladding panel (1) by means of one or more rivets (40).

5. Box (100) according to any one of the preceding claims, wherein the deformed portion (31) has a profile folded in broken lines, or in mixed broken/wavy lines.

6. Electrical converter, in particular for a transport vehicle, **characterised in that** it comprises at least one box (100) according to any one of the preceding claims.

7. Transport vehicle, **characterised in that** it comprises at least one electrical converter according to claim 6.
